# EUROPEAN PATENT APPLICATION

(11) **EP 4 560 325 A1**
(43) Date of publication of application: **28.05.2025**
(21) Application number: 24181167.8
(22) Date of filing: 10.06.2024
(51) Int. Cl.: G01R 1/22, G01R 15/18

(54) **CLAMP METER WITH ROTATING CLAMP JAW**

(30) Priority: 23.11.2023 CN 202311579654
(71) Applicant: Fluke Corporation, Everett, WA 98203 (US)
(72) Inventor: LI, Fang, Everett, 98203 (US); ZOU, Hongchao, Everett, 98203 (US)
(74) Representative: HGF

(57) **Abstract**

A clamp meter device has a meter body and a measuring section. The measuring section includes a fixed jaw having first and second legs that extend from the meter body. A movable jaw is rotatably coupled to the first leg of the fixed jaw at a rotation axis and is configured to rotate between a closed position and an open position. When the movable jaw is in the open position, the measuring section is able to receive an electrical conductor between the first and second legs of the fixed jaw, and when the movable jaw is in the closed position, the movable jaw extends from the first leg to the second leg to form a measuring loop for measuring an electrical characteristic of the electrical conductor without galvanically contacting the electrical conductor, A method is also provided for using the clamp meter for electrical measurement.

## Description

### BACKGROUND

### Technical Field

The present disclosure relates to a clamp meter having a mechanical linkage for a rotating clamp jaw, and a method for measuring electrical current using the clamp meter.

### Description of the Related Art

Conventional clamp meters are widely used and available in a variety of industrial, commercial, and/or residential settings as an electrical test tool that measures electrical current. Clamp meters are of critical importance for engineers and/or technicians to troubleshoot and resolve electrical issues of operating equipment. Conventional clamp meters are typically comprised of laterally opening rigid jaws that extend from a clamp meter body, and have a rotating trigger positioned on the side of the clamp meter body that can open the jaws. The jaws can clamp around a wire, cable, or other conductor and measure electrical current without having to disconnect or deenergize connected equipment.

Conventional current transformer clamp meters, for example, may measure alternating current (AC) without having to make direct contact with the conductor. Some variations of clamp meters, such as Hall-effect clamp meters, may measure both alternating current (AC) and direct current (DC) Measurement circuitry coupled to the jaws can detect the magnetic field caused by the flow of current and relay an accurate measurement of the current. Despite the varying types of clamp meters discussed, there remains a need for a clamp meter with rigid jaws that can operate in tight or confined spaces, e.g., where a conductor to be measured has tiny adjacent space for the jaws of the clamp meter to open and fit around the conductor. There also remains a high demand to measure both alternating current (AC) and direct current (DC) of high magnitude with high accuracy in a variety of markets, including the solar energy storage market, in which conductors for conveying high amounts of current may have a form factor with minimal lateral space that precludes the use of a conventional clamp meter to measure current in the conductors.

### BRIEF SUMMARY

Disclosed herein is a clamp meter having a mechanical linkage for a rotating clamp jaw, wherein the mechanical linkage enables the clamp meter to open, fit around a conductor, and close, even when the conductor has limited lateral space to receive the open jaws of the clamp meter.

Embodiments of the present disclosure include a clamp meter comprising a meter body and a measuring section. The measuring section includes a fixed jaw having a first leg and a second leg that extend from the meter body. The measuring section further includes a movable jaw that is rotationally coupled to the first leg of the fixed jaw. The movable jaw rotates about a rotation axis between a closed position and an open position.

When the movable jaw is in the open position, the measuring section is able to receive an electrical conductor between the first and second legs of the fixed jaw, after which the movable jaw can be rotated to the closed position for measuring current in the electrical conductor. When the movable jaw is in the closed position, the movable jaw extends from the first leg to the second leg of the fixed jaw, and in cooperation, the fixed jaw and the movable jaw form a measuring loop for measuring an electrical characteristic of the electrical conductor without galvanically contacting the electrical conductor.

As will be discussed in greater detail herein, embodiments of the clamp meter may include one or more of the following features or aspects in any combination: wherein the measuring section has an overall width when the movable jaw is in the closed position, and the overall width of the measuring section is maintained when the movable jaw is rotated to the open position; wherein the rotation axis is defined at a first end of the movable jaw, and a second end of the movable jaw abuts the second leg of the fixed jaw when the movable jaw is in the closed position; wherein the movable jaw is rotationally coupled to the first leg of the fixed jaw at a distal end of the first leg; and wherein the movable jaw is biased towards the closed position.

Also as discussed herein, embodiments of the clamp meter may include one or more of the following features or aspects in any combination: the clamp meter further comprising an actuator configured to move the movable jaw between the closed position and the open position, wherein the movable jaw is rotationally coupled to the first leg of the fixed jaw by a rotation pair that defines the rotation axis on the movable jaw and a cam pair that couples the movable jaw to the actuator to convert motion of the actuator to rotation of the movable jaw about the rotation axis; wherein the rotation pair rotationally couples the movable jaw to the first leg of the fixed jaw at a distal end of the first leg, and in the closed position the movable jaw is positioned transverse to the first and second legs of the fixed jaw; wherein the cam pair cooperates with the rotation pair to convert linear motion of the actuator to rotation of the movable jaw about the rotation axis; wherein the cam pair is comprised of a pin that couples the movable jaw to a mechanical linkage of the actuator that urges movement of the pin when the actuator is moved; wherein the actuator includes a sliding switch, and the pin of the cam pair is positioned within a slot in the mechanical linkage such that linear motion of the sliding switch causes the mechanical linkage to exert a force on the pin that urges the pin to move relative to the rotation pair; the clamp meter further comprising a spring element operably connected to the actuator to bias the movable jaw toward the closed position; the clamp meter further comprising a slider pair comprised of a pin and corresponding slot that couples the fixed jaw to the mechanical linkage and guides linear motion of the actuator with respect to the fixed jaw; wherein the first and second legs of the fixed jaw are spaced apart from each other and form a fork that is sized to receive an electrical conductor when the movable jaw is in the open position; wherein the first and second legs of the fixed jaw form a U-shaped fork; and wherein a first end of the movable jaw is rotationally coupled to an end of the first leg of the fixed jaw, and when the movable jaw is in the closed position, a second end of the movable jaw is positioned against an end of the second leg of fixed jaw such that the movable jaw bridges the first and second legs of the fixed jaw.

The present disclosure also provides methods for electrical measurement using a clamp meter as described herein. For example, a method includes actuating a movable jaw of the clamp meter to open a measuring section of the clamp meter, the measuring section including first and second legs of a fixed jaw that extend from a meter body of the clamp meter, wherein actuating the movable jaw includes rotating the movable jaw about a rotation axis on the movable jaw between a closed position and an open position, and when the movable jaw is actuated to the open position, receiving an electrical conductor into the measuring section. In some cases, the rotation axis is arranged away from the meter body of the clamp meter. When the movable jaw is actuated to the closed position, the movable jaw bridges the first and second legs of the fixed jaw, and in cooperation, the fixed jaw and the movable jaw form an electrical measuring loop around the electrical conductor to measure an electrical characteristic of the electrical conductor without galvanically contacting the electrical conductor.

### BRIEF DESCRIPTION OF THE SEVERAL VIEWS OF THE DRAWINGS

Aspects of the present disclosure are best understood from the following detailed description when read with the accompanying figures. It will be understood that these accompanying drawings merely illustrate certain embodiments in accordance with the present application and should not be considered as limitation to the scope of the present application. The aforementioned features and other features of the present application will be fully understood by referring to the accompanying drawings and the appended claims. Unless otherwise specified, accompanying features in these figures are not necessarily drawn to scale.
Fig. 1 illustrates a front view of a prior art clamp meter.
Fig. 2 illustrates a front view of a clamp meter according to the present disclosure, wherein a movable jaw of the clamp meter is shown in an open position.
Fig. 3 illustrates a front view of the clamp meter in Fig. 2 with the movable jaw shown in a closed position.
Fig. 4 illustrates a back view of the clamp meter in Fig. 2, wherein features inside the clamp meter are shown.
Fig. 5 illustrates a front view of the clamp meter in Fig. 2, with the movable jaw in process of being actuated from the closed position to the open position, or vice versa.
Fig. 6 illustrates a partial cross-sectional side view of the clamp meter in Fig. 2 with the movable jaw in the closed position.

### DETAILED DESCRIPTION

Electrical test instruments, such as clamp meters, are used to perform daily maintenance and troubleshooting tasks in a variety of industrial settings. Particularly, there is a high demand to measure both AC and DC current of high magnitude with high accuracy, ideally using a clamp meter. For example, in the solar energy market, a technician may wish to measure a three-phase 2000A busbar comprised of three parallel 80mm wide copper bars having 40mm of space between the copper bars. In this particular scenario, a conventional AC/DC clamp meter that has laterally-opening rigid jaws and a rotating side trigger to open the jaws is not able to fit around the copper bars. When opened, the width, geometry, and positioning of the jaws is larger than the gap between the adjacent copper bars. This prevents the jaws from fitting around the copper bars, especially the middle copper bar.

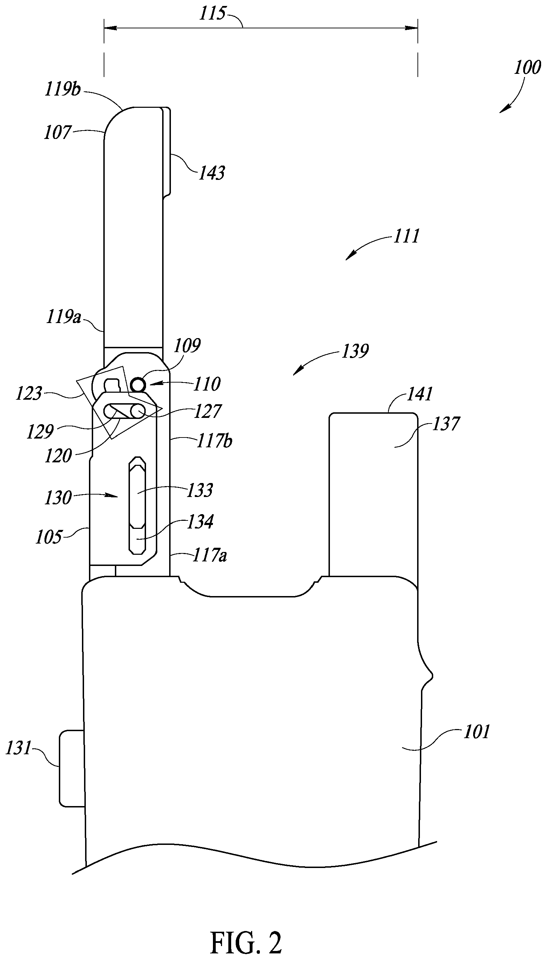

Additionally, conventional AC/DC clamp meters with rigid jaws that use a rotating side trigger to open the rigid jaws are not easily maneuverable in tight or confined spaces. A flexible Rogowski coil ("R-coil") probe may be used to reach around and surround conductor to be measured. However, R-coil probes can only be used for AC current measurement, which creates an issue when specifically trying to measure high magnitude current of solar energy systems, which primarily consist of DC current. The present disclosure solves these problems by providing a clamp meter with a rigid, movable jaw that can open and allow the clamp meter to fit around a conductor having limited space to the side of the conductor, and close again to measure electrical current in the conductor. Embodiments of the disclosure are illustrated in Figs. 2-6 and discussed in greater detail below. In one example, a clamp meter includes a mechanical linkage that enables the rotational opening and closing of a movable jaw around a rotation axis. The movable jaw rotates between a closed position and an open position. When the movable jaw is in the open position, the clamp meter can receive an electrical conductor between first and second legs of a fixed jaw. When the movable jaw is in the closed position, the movable jaw extends from the first leg to the second leg of the fixed jaw, and together, the fixed jaw and the movable jaw form an electrical measuring loop for measuring an electrical characteristic of the electrical conductor without galvanically contacting the electrical conductor. With this configuration, the improved clamp meter can operate in environments where a conductor to be measured has limited space around the conductor.

In some cases, the movable jaw is rotationally coupled to the fixed jaw outside of and/or away from the meter body of the clamp meter. When the movable jaw is in the open position, the movable jaw and the first leg of the fixed jaw (to which the movable jaw is rotationally connected) have a width that is sufficiently narrow such that the movable jaw and the first leg of the fixed jaw can fit through the lateral space next to a conductor to be measured. At the same time, the width of the second leg of the fixed jaw is sufficiently narrow such that the second leg of the fixed jaw can fit through the lateral space next to the other side of the conductor to be measured. Once the conductor to be measured has been received into the measurement section between the first and second legs of the fixed jaw, the movable jaw (now positioned behind the conductor) is rotated to the closed position, thereby forming a measuring loop that allows the clamp meter to measure an electrical characteristic of the conductor. In some cases, the clamp meter is able to maintain an overall width of a measuring section of the clamp meter even when the movable jaw is rotated open and closed. In other words, in such cases the overall width of the measuring section does not change or only changes, like 10%, when the movable jaw is rotated open and closed. In the following description, certain specific details are set forth in order to provide a thorough understanding of various disclosed implementations. However, a person skilled in the art will recognize that additional implementations may be practiced without one or more of these specific details, or with other methods, components, materials, etc. Additionally, reference throughout this specification to "one embodiment" or "an embodiment" means that a particular feature, structure, or characteristic described in connection with the embodiment is included in at least one embodiment and may be included in other embodiments as well. Furthermore, appearance of the phrase "in at least one embodiment" in this specification does not necessarily refer to only one embodiment. The particular features, structures, or characteristics of the various embodiments described herein may be combined in any suitable manner in yet additional embodiments. The term "implementation" may be interpreted similar to the term "embodiment" unless otherwise dictated by context.

For the purposes of the present disclosure, unless otherwise indicated, the phrase "A and B" is nonlimiting and means one or more of (A) and one or more of (B); the phrase "A or B" is nonexclusive and means one or more of (A), one or more of (B), or one or more of (A and B); the phrase "A and/or B" means one or more of (A), one or more of (B), or one or more of (A and B); the phrase "at least one of A and B" and the phrase "one or more of A and B" both mean one or more of (A) and one or more of (B); and the phrase "at least one of A or B" and the phrase "one or more of A or B" both mean one or more of (A), one or more of (B), or one or more of (A and B). In the above, A and B represent any form or type of element, feature, arrangement, component, structure, aspect, action, step, etc.

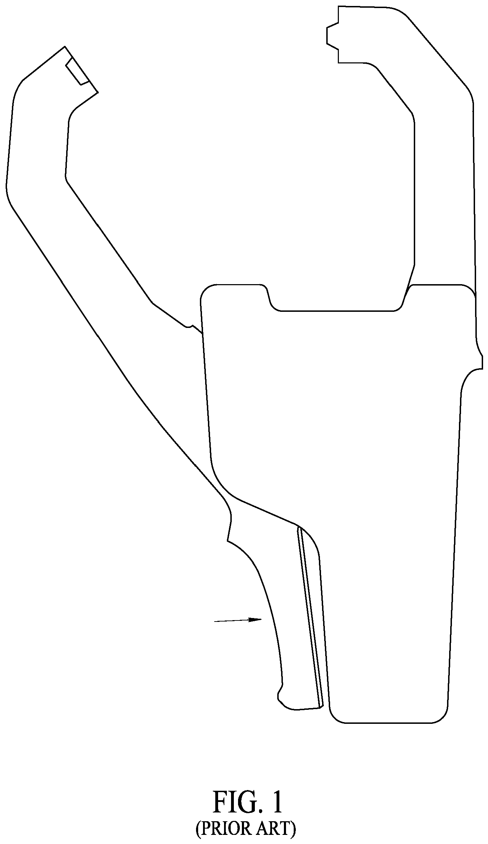

An example of a conventional clamp meter known in the prior art is shown in Fig. 1. The clamp meter depicted in Fig. 1 includes a laterally opening rigid jaw that extends from a clamp meter body, and a trigger positioned on the side of the clamp meter body that, when pressed, operates to rotate the jaw to an open position as shown in Fig. 1. The laterally opening jaw rotates about an axis that is arranged within the meter body. In particular, the device in Fig. 1 comprises a hinged jaw clamp positioned opposite to a fixed jaw clamp. The device further comprises a jaw rotational axis that is configured within the clamp meter body. When the trigger is pressed toward the clamp meter body, the hinged jaw clamp rotates about the jaw rotational axis within the clamp meter body from a closed position to an open position. Each of the hinged jaw clamp and the fixed jaw clamp has a hooked portion at their distal end that, when moved to the open position, is wider than the lateral space available to the sides of a conductor to be measured. In such cases, the conventional clamp meter is not able to fit around the conductor to be measured.

Thus, conventional clamp meters as shown in Fig. 1 are not configured to open and fit around conductors in a limited space. Clamp meters of the type depicted in Fig. 1 may be able to fit around wires in some cases but will fail to fit around other conductors in limited-space environments. On the other hand, clamp meters as described herein are suitable for measuring current in conductors in limited-space environments, and accordingly provide numerous benefits as detailed herein.

Fig. 2 depicts a clamp meter 100 embodying principles of the present disclosure. The clamp meter 100 can fit around a conductor having limited space to the side of the conductor. The clamp meter 100 includes a meter body 101, wherein the meter body 101 encapsulates components of the clamp meter 100 that are used for measuring electrical characteristics as known in the art. For example, the meter body 101 may be configured with a variety of conventional electrical measurement circuitry. The electrical measurement circuitry is not shown for simplicity of the drawings.

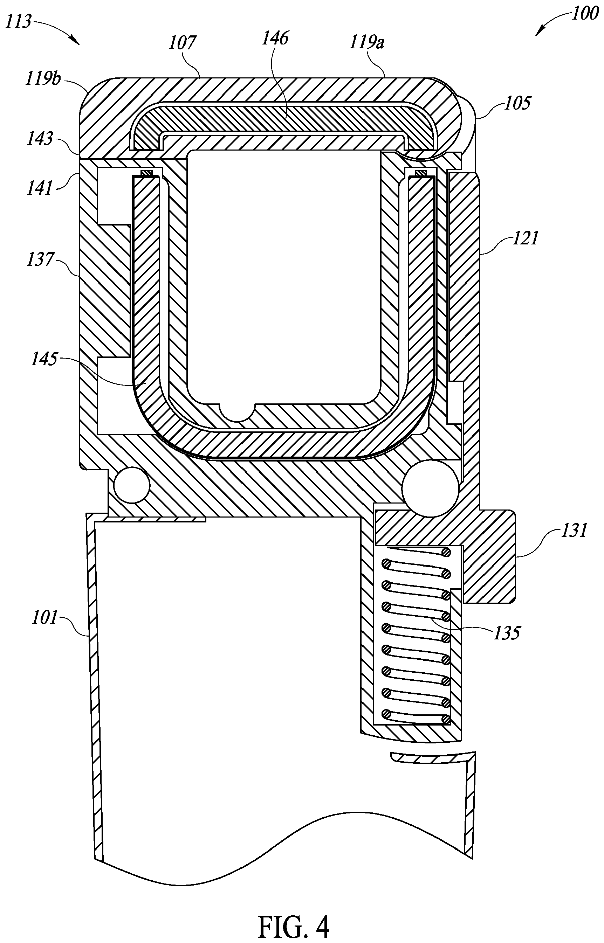

The clamp meter 100 further includes a measuring section having a fixed jaw and a movable jaw. While the fixed jaw is typically (though not necessarily) an integral single-piece element, e.g., having a single integral magnetically conductive core 145 as shown in Fig. 4, for purposes of description herein, the fixed jaw is considered as having a first leg 105 extending from the meter body 101 and a second leg 137 extending from the meter body 101. The first and second legs 105, 137 of the fixed jaw, as well as the movable jaw 107, may be coated with plastic moldings and may be composed of ferrite iron or other similar magnetically conductive core materials. In Fig. 2, the first leg 105 of the fixed jaw extends upward from a side of the meter body 101 and includes a proximal end 117a and a distal end 117b located opposite to the proximal end 117a, away from the meter body 101. The second leg 137 of the fixed jaw also extends upward from a side of the meter body 101. The second leg 137 of the fixed jaw is spaced apart from the first leg 105 and may extend from the meter body 101 parallel to the first leg 105.

The first and second legs 105, 137 of the fixed jaw are shown in Fig. 2 as extending from the meter body 101 parallel to each other, but alternatively they may be positioned relative to the meter body 101 in other configurations as needed. The second leg 137 of the fixed jaw includes a first end 141 positioned away from the meter body 101. The first end 141 is structured to receive a second end 119b of the movable jaw 107, as discussed in further detail below, when the movable jaw 107 is in the closed position.

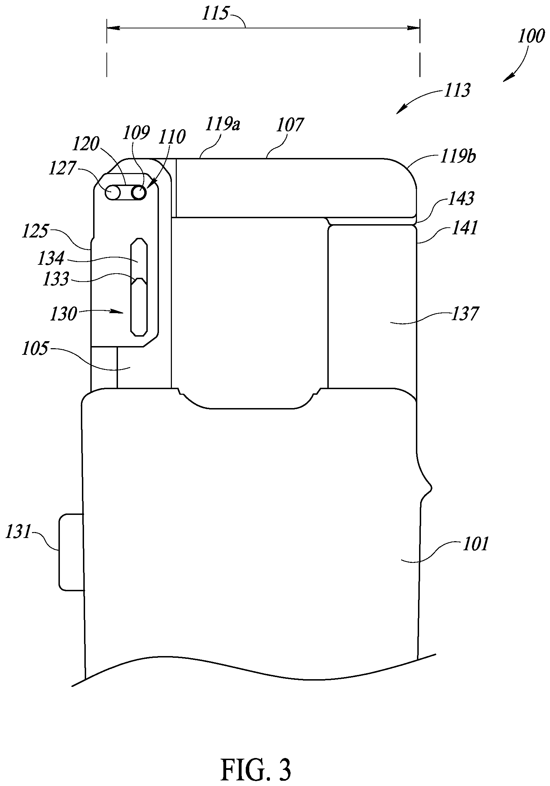

The movable jaw 107 includes a rotation axis 109 that rotatably couples the movable jaw 107 to the first leg 105 of fixed jaw. The rotation axis 109 in Fig. 2 is advantageously coupled to the first leg 105 at the distal end 117b of the first leg 105, away from the meter body 101, as opposed to within or on the meter body 101. The rotation axis 109 enables the movable jaw 107 to rotate about the rotation axis 109 from a closed position 113 as shown in Fig. 3 to an open position 111 as shown in Fig. 2. While in the open position 111, the movable jaw 107 has an upright stance approximately in line with the first leg 105 of the fixed jaw. Coupling the rotation axis 109 of the movable jaw 107 to the first leg 105 of the fixed jaw, away from the meter body 101, results in a configuration that reduces the amount of space required to fit the clamp meter 100 around an electrical conductor to obtain electrical measurements using the clamp meter 100. As described below, the first leg 105 of the fixed jaw has an aperture through which a pin of the movable jaw 107 extends. Together the aperture and pin form a rotation pair 110 that provides the rotation axis 109 about which the movable jaw 107 rotates.

The clamp meter 100 further includes an actuator, which as illustrated may include a sliding switch 131. The sliding switch 131 is slidably mounted on the first leg 105 of the fixed jaw. In various embodiments, the sliding switch 131 may be positioned on the left side, right side, front, or bottom of the meter body 101. The sliding switch 131 may be configured and/or located in a manner that is convenient for the user. As will be understood from the description below, the movable jaw 107 and the actuator (sliding switch) 131 include components that together form a cam pair 123. The cam pair 123 couples the movable jaw 107 and the sliding switch 131 in such a manner as to convert motion of the sliding switch 131 to rotation of the movable jaw 107 about the rotation axis 109.

The clamp meter 100 further includes a slider pair 130 comprising components of the first leg 105 of the fixed jaw and the sliding switch 131. The sliding switch 131 may move linearly as guided by a guide rib 133 sliding in a vertically oriented channel 134, as shown. The guide rib 133, which may be defined on the first leg 105, guides the sliding switch 131 to move linearly in a downward or an upward motion, dependent on the operation and configuration of the sliding switch 131. In Figs. 2 and 3, the guide rib 133 is arranged within the channel 134 defined in a mechanical linkage 125 that is coupled to or integrated with the sliding switch 131. The channel 134 is interposed between the proximal end 117a and the distal end 117b of the first leg 105 of the fixed jaw. However, in alternative embodiments, the guide rib 133 may be positioned in other locations of the clamp meter 100 to achieve the desired operation of guiding the linear motion of the sliding switch 131 along a linear path.

The movable jaw 107 comprises a pin 127 that is positioned within a slot 120. The pin 127 may extend through a groove or slot 129 defined in the distal end 117b of the first leg 105 of the fixed jaw. The pin 127 may be formed of any suitable structure that enables the pin 127 to move relative to the rotational axis 109 when urged by movement of the sliding switch 131. This combination of the pin 127 and the slot 120 (comprising the cam pair 123), when actuated by movement of the sliding switch 131, provides a simple yet robust mechanism for causing the movable jaw 107 to swing or rotate from the closed position 113 to the open position 111, and vice versa. While the slot 129, if used, is illustrated as being arc-shaped, the slot 129 may also encompass varying structures or shapes that help prevent the fixed jaw from interfering with the movement of the pin 127 as described above.

The size of the movable jaw 107 and other components of the clamp meter 100 may vary and may not be to scale as shown in the figures. For example, the size of the movable jaw 107 may be narrower, in some cases depending on the construction of the first and second legs 105, 137 of the fixed jaw. The size of the movable jaw 107 may also be determined by the intended electrical measurement requirements of the clamp meter 100. Preferably the movable jaw 107 and the first and second legs 105, 137 of the fixed jaw are not so large as to make the clamp meter 100 too heavy to carry and maneuver as needed. Thus, the size of the first and second legs 105, 137 and the movable jaw 107 may be determined according to the anticipated use of the clamp meter 100.

The movable jaw 107 has a first end 119a and an opposing second end 119b. In at least one implementation, the movable jaw 107 further comprises a mating tongue 143 positioned on the second end 119b of the movable jaw 107. The mating tongue 143 is shaped to fit with a corresponding groove 142 on the first end 141 of the second leg 137. When the clamp meter 100 is in the open position 111, the movable jaw 107 is aligned with the first leg 105 of the fixed jaw. When the movable jaw 107 is aligned with the first leg 105, the movable jaw 107 and the first leg 105 have a width that fits within the lateral space to one side of the conductor to be measured, while the second leg 137 of the fixed jaw has a width that fits within the lateral space to the other side of the conductor to be measured. Accordingly, the clamp meter 100 can open and maneuver around a conductor having limited space on either side of the conductor, then close around the conductor for measuring electrical characteristics (e.g., current) flowing in the conductor without galvanically contacting the conductor.

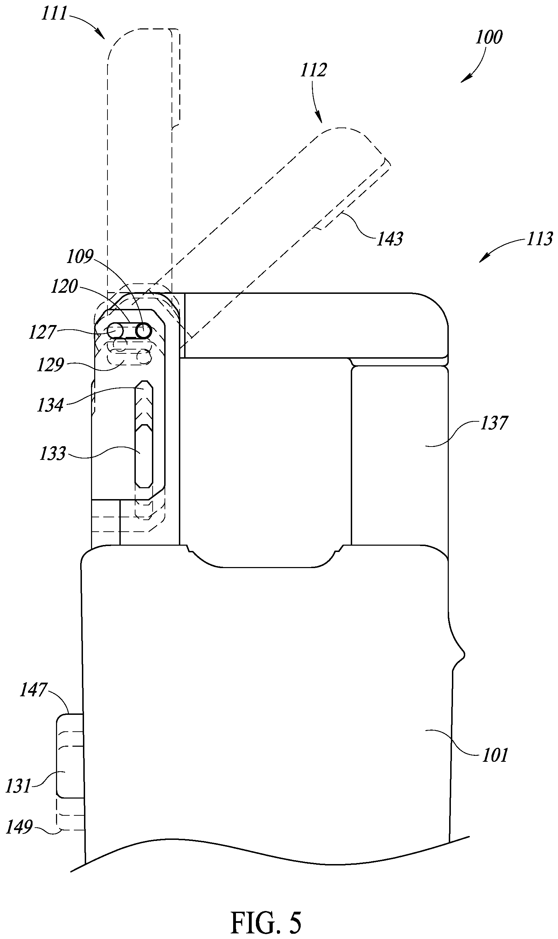

When the clamp meter 100 is in the closed position 113, the movable jaw 107 is transverse to the first leg 105 and the mating tongue 143 of the movable jaw 107 fits within the groove 142 in the first end 141 of the second leg 137. Together, the fixed jaw (including the first and second legs 105, 137) and the movable jaw 107 create a measuring section 115 with respect to the meter body 101 for measuring electrical characteristics of a conductor received into the measuring section 115. The measuring section 115 includes the area between the first and second legs 105, 137 of the fixed jaw. The measuring section 115 is bounded by an upper end of the meter body 101 and by the movable jaw 107 when the movable jaw 107 is in the closed position 113 (as shown in Fig. 3). The measuring section 115 contains the area where an electrical conductor to be measured is positioned. In the implementation shown in Figs. 2 to 4, the fixed jaw (including first and second legs 105, 137) forms a fork 139 that can receive an electrical conductor to be measured. In the illustrated embodiment, the fixed jaw forms a U-shaped fork 139, e.g., as best seen in Figs. 4 and 5.

When the movable jaw 107 is in the closed position 113 (as shown in Fig. 3), the U-shaped fork 139 has an overall width that is maintained whether the clamp meter 100 is in the closed position 113 (as shown in Fig. 3) or in the open position 111 (as shown in Fig. 2). In other words, when the movable jaw 107 swings open to allow the U-shaped fork 139 to receive an electrical conductor, the overall width of the U-shaped fork does not substantially change.

By rotatably coupling the movable jaw 107 to the first leg 105 of the fixed jaw at the distal end 117b of the first leg 105, with the fixed jaw arranged as having the U-shaped fork 139 as shown, the clamp meter 100 is allowed to open and access electrical conductors having narrow lateral space to accurately measure current in the electrical conductors. The clamp meter 100 is capable of opening and maneuvering around a conductor (not shown) having limited spaced on either side of the conductor. The clamp meter 100 can then close around the conductor for electrical measurement of current flowing in the conductor without galvanically contacting the conductor.

Fig. 3 depicts the clamp meter 100 of Fig. 2 in the closed position 113.

In the closed position 113, the movable jaw 107 bridges from the first leg 105 of the fixed jaw to the second leg 137 of the fixed jaw, and the mating tongue 143 on the second end 119b of the movable jaw 107 mates with a corresponding groove on the first end 141 of the second leg 137. The second end 119b of the movable jaw 107 abuts, rests on, or is otherwise held against the first end 141 of the second leg 137. The movable jaw 107 is positioned transverse to the first and second legs 105, 137 of the fixed jaw, and closes the electrical measuring loop of the measuring section 115.

The sliding switch 131 is preferably biased so that, by default, the fixed jaw holds the movable jaw 107 in the closed position 113. In this position, the measuring section 115, including the U-shaped fork 139, is arranged to obtain electrical measurements of an electrical conductor that has been received into the area of the U-shaped fork 139.

Fig. 4 provides a view of interior components of the clamp meter 100 in the closed position 113. An actuator 121 having a sliding switch 131 is configured to move the movable jaw 107 from the closed position 113 to the open position 111, or vice versa. The sliding switch 131 is coupled to or integrated with the actuator 121. As depicted in Fig. 2, the movable jaw 107 is rotationally coupled to the first leg 105 of the fixed jaw by the rotation pair 110 at the rotational axis 109. The actuator 121 is coupled to the cam pair 123 such that motion of the actuator 121 causes motion of the cam pair 123 relative to the rotational axis 109. This arrangement converts linear motion of the actuator 121 to rotational motion of the movable jaw 107.

The actuator 121 includes a mechanical linkage 125 (Fig. 3) coupled to the cam pair 123 (including pin 127) as described above such that linear motion of the actuator 121 causes rotational motion of the movable jaw 107 about the rotation axis 109. The mechanical linkage 125 in this embodiment has a horizontally arranged slot 120 that receives the pin 127 of the cam pair 123. When a linear force is applied to the sliding switch 131, causing the sliding switch 131 to move in a downward direction, the mechanical linkage 125 connected to the sliding switch 131 pulls on the pin 127 and urges the pin 127 to move downward as shown in Fig. 5, causing the movable jaw 107 to rotate about the rotational axis 109 from the closed position to the open position. The actuator 121 (including the sliding switch 131) may be configured to move in a downward-to-upward motion, or in an upward-to-downward motion. In some embodiments, based upon the configuration of the sliding switch 131, the actuator 121 causes the swinging motion of the movable jaw 107 between the closed and open positions. The arrangement of the rotation pair 110 at the rotational axis 109, the cam pair 123, and sliding pair including the guide rib 133, provides a simple yet robust mechanical linkage 125 that converts linear motion of the actuator 121 to rotational motion of the movable jaw 107.

The clamp meter 100 further comprises a biasing element, such as a coil or spring element 135 housed within the meter body 101. In at least one embodiment, the spring element 135 is operably connected to the actuator 121. For example, in one embodiment, the spring element 135 is housed in the meter body 101 and coupled to the actuator 121. Until motion of the sliding switch 131 causes the actuator 121 to exert a downward compressive force on the spring element 135, the movable jaw 107 remains in the closed position 113. When a downward force is exerted on the sliding switch 131, the actuator 121 moves downward and compresses the spring element 135. This compression of the spring element 135 causes a spring force counterpressure to be exerted that pushes the actuator 121 in an upward direction when the downward force on the sliding switch 131 is released.

As described above, the movable jaw 107 in the closed position 113 bridges the legs of the fixed jaw and together with the fixed jaw forms an electrical measuring loop of the clamp meter 100. More specifically, in the closed position 113, the magnetically conductive core 145 in the U-shaped fork 139 in conjunction with the magnetically conductive material 146 in the movable jaw 107 forms the electrical measuring loop of the clamp meter 100. Furthermore, as shown in Fig. 4, the mating tongue 143 on the second end 119b of the movable jaw 107 is flush with the corresponding groove on the first end 141 of the second leg 137 of the fixed jaw.

Fig. 5 depicts the opening and/or closing of the clamp meter 100 for electrical measurement of a conductor received into the measuring section 115 of the clamp meter 100. The features of the clamp meter 100 in Fig. 5 are as described in Figs. 2 to 4 above.

In at least one embodiment, the sliding switch 131 is operably maneuverable in conjunction with the spring element 135. The sliding switch 131 is normally held in a static switch position 147 in which the movable jaw 107 is in the closed position 113. To operate the clamp meter 100, the sliding switch 131 is pressed in a downward motion toward an actuated switch position 149 causing the movable jaw 107 to be rotated to the open position 111. When the sliding switch 131 transitions between the static switch position 147 and the actuated switch position 149, the movable jaw 107 rotates through a transitional position 112 as shown. As long as a downward force on the sliding switch 131 is maintained, the movable jaw 107 remains in the open position 111. When the downward force on the sliding switch 131 is released, the upward pressure exerted by the compressed spring element 135 (Fig. 4) causes the sliding switch 131 to move upward, causing the movable jaw 107 to rotate to the closed position 113. In other embodiments, the sliding switch 131 may be pressed in an upward direction to maneuver the movable jaw 107 between the closed and open positions 113, 111 as described above.

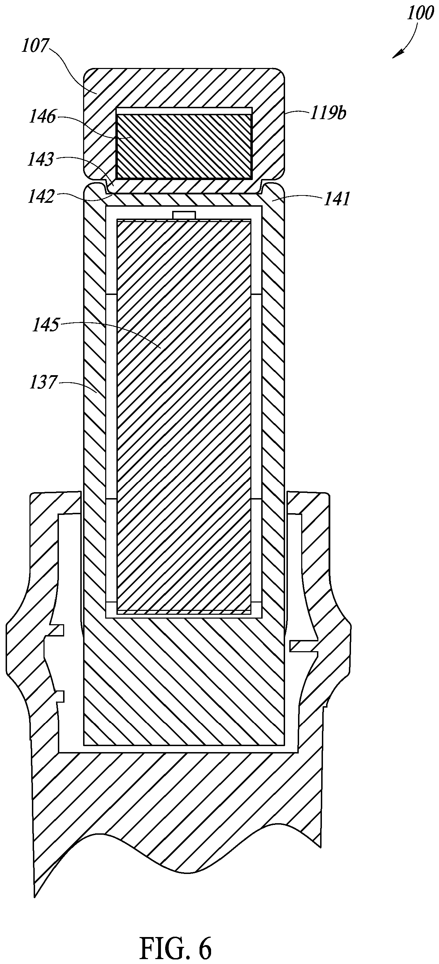

Fig. 6 depicts a partial cross-sectional side view of the clamp meter 100 in the closed position 113. For purposes of illustration, only the second leg 137 of the fixed jaw and the movable jaw 107 are shown. As mentioned above, the second end 119b of the movable jaw 107 comprises a mating tongue 143 and when the movable jaw 107 is in the closed position 113 the mating tongue 143 fits within the groove 142 defined in the first end 141 of the second leg 137 of the fixed jaw. This mating tongue 143 and groove 142 aligns the second end 119b of the movable jaw 107 with the first end 141 of the second leg 137, which is important for proper operation of the electrical measurement loop formed by the fixed jaw and the movable jaw in the closed position 113.

As shown in Fig. 6, the mating tongue 143 of the movable jaw 107 comprises a narrower width than that of the second leg 137 of the fixed jaw, which enables the mating tongue 143 of the movable jaw 107 to fit within the recessed groove 142 of the first end 141 of the second leg 137. The recessed groove 142 may encompass various shapes, dependent on the configuration of the mating tongue 143, to ensure alignment of the movable jaw 107 with the second leg 137 of the fixed jaw. In some embodiments, the first end 141 of the second leg 137 may be structured with an extrusion or rib that protrudes as a tongue that mates with a corresponding groove defined in the second end 119b of the movable jaw 107. In either case, proper alignment of the second leg 137 with the movable jaw 107 completes the electrical measuring loop and enables the measurement circuitry of the clamp meter to properly and accurately measure electrical characteristics of an electrical conductor being measured.

The following section of the description relates to further examples. The examples in this section are not claims. The claims are set forth below in the later section headed "claims".

Example 1 comprises a clamp meter, comprising: a meter body; and a measuring section that includes: a fixed jaw, wherein the fixed jaw includes a first leg and a second leg extending from the meter body; and a movable jaw that is rotationally coupled to the first leg of the fixed jaw, wherein the fixed jaw in cooperation with the movable jaw forms an electrical measuring loop for measuring an electrical characteristic of an electrical conductor without galvanically contacting the electrical conductor.

Example 2 may comprise the clamp meter of example 1, or any other example contained herein, wherein the movable jaw is configured to rotate about a rotation axis between a closed position and an open position, and when the movable jaw is in the open position, the measuring section is able to receive the electrical conductor between the first leg and the second leg of the fixed jaw, and when the movable jaw is in the closed position, the movable jaw extends from the first leg to the second leg.

Example 3 may comprise the clamp meter of example 2, or any other example contained herein, wherein the measuring section has an overall width when the movable jaw is in the closed position, and the overall width of the measuring section is maintained when the movable jaw is rotated to the open position; or wherein the rotation axis is defined at a first end of the movable jaw, and a second end of the movable jaw abuts the second leg of the fixed jaw when the movable jaw is in the closed position.

Example 4 may comprise the clamp meter of example 2 or 3, or any other example contained herein, wherein the movable jaw is biased towards the closed position.

Example 5 may comprise the clamp meter of any of examples 1 to 4, or any other example contained herein, wherein the movable jaw is rotationally coupled to the first leg of the fixed jaw at a distal end of the first leg.

Example 6 may comprise the clamp meter of any of examples 1 to 5, or any other example contained herein, further comprising an actuator configured to move the movable jaw between a closed position and an open position, wherein: the movable jaw is rotationally coupled to the first leg of the fixed jaw by a rotation pair that defines a rotation axis on the movable jaw, and a cam pair couples the movable jaw to the actuator to convert motion of the actuator to rotation of the movable jaw about the rotation axis.

Example 7 may comprise the clamp meter of example 6, or any other example contained herein, wherein the rotation pair rotationally couples the movable jaw to the first leg of the fixed jaw at a distal end of the first leg, and in the closed position the movable jaw is positioned transverse to the first and second legs of the fixed jaw.

Example 8 may comprise the clamp meter of example 6 or 7, or any other example contained herein, wherein the cam pair cooperates with the rotation pair to convert linear motion of the actuator to rotation of the movable jaw about the rotation axis.

Example 9 may comprise the clamp meter of example 8, or any other example contained herein, wherein the cam pair is comprised of a pin that couples the movable jaw to a mechanical linkage of the actuator that urges movement of the pin when the actuator is moved.

Example 10 may comprise the clamp meter of example 9, or any other example contained herein, wherein the actuator includes a sliding switch, and the pin of the cam pair is positioned within a slot in the mechanical linkage such that linear motion of the sliding switch causes the mechanical linkage to exert a force on the pin that urges the pin to move relative to the rotation pair.

Example 11 may comprise the clamp meter of any of examples 6 to 10, or any other example contained herein, further comprising a spring element operably connected to the actuator to bias the movable jaw toward the closed position.

Example 12 may comprise the clamp meter of any of examples 6 to 11, or any other example contained herein, further comprising a slider pair comprised of a pin and corresponding slot that guides linear motion of the actuator with respect to the fixed jaw.

Example 13 may comprise the clamp meter of any of examples 1 to 12, or any other example contained herein, wherein the first and second legs of the fixed jaw are spaced apart from each other and form a fork that is sized to receive an electrical conductor when the movable jaw is in an open position.

Example 14 may comprise the clamp meter of example 13, or any other example contained herein, wherein the first and second legs of the fixed jaw form a U-shaped fork.

Example 15 may comprise the clamp meter of example 13 or 14, or any other example contained herein, wherein a first end of the movable jaw is rotationally coupled to an end of the first leg of the fixed jaw, and when the movable jaw is in a closed position, a second end of the movable jaw is positioned against an end of the second leg of fixed jaw such that the movable jaw bridges the first and second legs of the fixed jaw.

Example 16 provides a method for electrical measurement using a clamp meter, comprising: actuating a movable jaw of a clamp meter to open a measuring section of the clamp meter, the measuring section including first and second legs of a fixed jaw that extend from a meter body of the clamp meter, wherein actuating the movable jaw includes rotating the movable jaw about a rotation axis on the movable jaw between a closed position and an open position; receiving an electrical conductor into the measuring section when the movable jaw is actuated towards or at the open position; actuating the movable jaw to the closed position in which the movable jaw bridges the first and second legs of the fixed jaw, and together with the fixed jaw, forms a measuring loop around the electrical conductor in the measuring section; and measuring an electrical characteristic of the electrical conductor without galvanically contacting the electrical conductor.

Example 17 may comprise the method of example 16, or any other example contained herein, further comprising sliding an actuator along a linear path to actuate the movable jaw, wherein the movable jaw is rotationally coupled to the first leg of the fixed jaw by a rotation pair that defines the rotation axis on the movable jaw, and a cam pair is coupled to the movable jaw and the actuator to convert linear motion of the actuator to rotation of the movable jaw.

Example 18 may comprise the method of example 17, or any other example contained herein, wherein sliding the actuator along the linear path causes a mechanical linkage coupled to the cam pair to convert the linear motion of the actuator to rotation of the movable jaw about the rotation axis, the cam pair including a pin that couples the movable jaw to the mechanical linkage that urges movement of the pin relative to the rotation pair when the actuator is slid along the linear path.

Example 19 may comprise the method of example 17 or 18, or any other example contained herein, wherein the rotation pair rotationally couples the movable jaw to the first leg of the fixed jaw at a distal end of the first leg, and when the movable jaw is rotated from open position to the closed position, the movable jaw is positioned traverse to the first and second legs of the fixed jaw.

Example 20 may comprise the method of any of examples 16 to 19, or any other example contained herein, further comprising actuating the movable jaw to the closed position to close the measuring section of the clamp meter, wherein the first and second legs of the fixed jaw are spaced apart from each other and form a fork sized to receive the electrical conductor when the movable jaw is in the open position, and when the movable jaw is actuated to close the measuring section, the movable jaw rotates about the rotation axis to the closed position in which the movable jaw abuts the second leg of the fixed jaw and closes the measuring loop.

The various example embodiments described above can be combined to provide further embodiments. These and other changes can be made to the embodiments considering the above-detailed description. In general, in the following claims, the terms used should not be construed to limit the claims to the specific embodiments disclosed in the specification and the claims but should be construed to include all possible embodiments along with the full scope of equivalents to which such claims are entitled. Accordingly, the claims are not limited by the disclosure.

## Claims

1. A clamp meter, comprising:
a meter body; and
a measuring section that includes:
a fixed jaw, wherein the fixed jaw includes a first leg and a second leg extending from the meter body; and
a movable jaw that is rotationally coupled to the first leg of the fixed jaw, wherein the fixed jaw in cooperation with the movable jaw forms an electrical measuring loop for measuring an electrical characteristic of an electrical conductor without galvanically contacting the electrical conductor.

2. The clamp meter of claim 1, wherein the movable jaw is configured to rotate about a rotation axis between a closed position and an open position, and when the movable jaw is in the open position, the measuring section is able to receive the electrical conductor between the first leg and the second leg of the fixed jaw, and when the movable jaw is in the closed position, the movable jaw extends from the first leg to the second leg.

3. The clamp meter of claim 2, wherein the measuring section has an overall width when the movable jaw is in the closed position, and the overall width of the measuring section is maintained when the movable jaw is rotated to the open position; or wherein the rotation axis is defined at a first end of the movable jaw, and a second end of the movable jaw abuts the second leg of the fixed jaw when the movable jaw is in the closed position; and/or
wherein the movable jaw is biased towards the closed position.

4. The clamp meter of any of claims 1 to 3, wherein the movable jaw is rotationally coupled to the first leg of the fixed jaw at a distal end of the first leg.

5. The clamp meter of any of claims 1 to 4, further comprising an actuator configured to move the movable jaw between a closed position and an open position, wherein:
the movable jaw is rotationally coupled to the first leg of the fixed jaw by a rotation pair that defines a rotation axis on the movable jaw, and
a cam pair couples the movable jaw to the actuator to convert motion of the actuator to rotation of the movable jaw about the rotation axis; optionally wherein the rotation pair rotationally couples the movable jaw to the first leg of the fixed jaw at a distal end of the first leg, and in the closed position the movable jaw is positioned transverse to the first and second legs of the fixed jaw.

6. The clamp meter of claim 5, wherein the cam pair cooperates with the rotation pair to convert linear motion of the actuator to rotation of the movable jaw about the rotation axis; optionally wherein the cam pair is comprised of a pin that couples the movable jaw to a mechanical linkage of the actuator that urges movement of the pin when the actuator is moved; further optionally wherein the actuator includes a sliding switch, and the pin of the cam pair is positioned within a slot in the mechanical linkage such that linear motion of the sliding switch causes the mechanical linkage to exert a force on the pin that urges the pin to move relative to the rotation pair.

7. The clamp meter of claim 5, further comprising a spring element operably connected to the actuator to bias the movable jaw toward the closed position; and/or
further comprising a slider pair comprised of a pin and corresponding slot that guides linear motion of the actuator with respect to the fixed jaw.

8. The clamp meter of any of claims 1 to 7, wherein the first and second legs of the fixed jaw are spaced apart from each other and form a fork that is sized to receive an electrical conductor when the movable jaw is in an open position.

9. The clamp meter of claim 8, wherein the first and second legs of the fixed jaw form a U-shaped fork.

10. The clamp meter of claim 8 or 9, wherein a first end of the movable jaw is rotationally coupled to an end of the first leg of the fixed jaw, and when the movable jaw is in a closed position, a second end of the movable jaw is positioned against an end of the second leg of fixed jaw such that the movable jaw bridges the first and second legs of the fixed jaw.

11. A method for electrical measurement using a clamp meter, comprising:
actuating a movable jaw of a clamp meter to open a measuring section of the clamp meter, the measuring section including first and second legs of a fixed jaw that extend from a meter body of the clamp meter, wherein actuating the movable jaw includes rotating the movable jaw about a rotation axis on the movable jaw between a closed position and an open position;
receiving an electrical conductor into the measuring section when the movable jaw is actuated towards or at the open position;
actuating the movable jaw to the closed position in which the movable jaw bridges the first and second legs of the fixed jaw, and together with the fixed jaw, forms a measuring loop around the electrical conductor in the measuring section; and
measuring an electrical characteristic of the electrical conductor without galvanically contacting the electrical conductor.

12. The method of claim 11, further comprising sliding an actuator along a linear path to actuate the movable jaw,
wherein the movable jaw is rotationally coupled to the first leg of the fixed jaw by a rotation pair that defines the rotation axis on the movable jaw, and a cam pair is coupled to the movable jaw and the actuator to convert linear motion of the actuator to rotation of the movable jaw.

13. The method of claim 12, wherein sliding the actuator along the linear path causes a mechanical linkage coupled to the cam pair to convert the linear motion of the actuator to rotation of the movable jaw about the rotation axis, the cam pair including a pin that couples the movable jaw to the mechanical linkage that urges movement of the pin relative to the rotation pair when the actuator is slid along the linear path.

14. The method of claim 12 or 13, wherein the rotation pair rotationally couples the movable jaw to the first leg of the fixed jaw at a distal end of the first leg, and when the movable jaw is rotated from open position to the closed position, the movable jaw is positioned traverse to the first and second legs of the fixed jaw.

15. The method of any of claims 16 to 14, further comprising actuating the movable jaw to the closed position to close the measuring section of the clamp meter,
wherein the first and second legs of the fixed jaw are spaced apart from each other and form a fork sized to receive the electrical conductor when the movable jaw is in the open position, and
when the movable jaw is actuated to close the measuring section, the movable jaw rotates about the rotation axis to the closed position in which the movable jaw abuts the second leg of the fixed jaw and closes the measuring loop.
